# EUROPEAN PATENT APPLICATION

(11) **EP 0 645 813 A2**
(43) Date of publication of application: **29.03.1995**
(21) Application number: 94113711.9
(22) Date of filing: 01.09.1994
(51) Int. Cl.: H01L 23/495

(54) **A method for applying adhesive to microelectronic chips**

(30) Priority: 28.09.1993 US 127538
(71) Applicant: National Starch and Chemical Investment Holding Corporation, Wilmington, Delaware 19809 (US)
(72) Inventor: Cho, Jae, Seoul (KR)
(74) Representative: Hagemann, Heinrich, Dr.rer.nat., Dipl.-Chem.

(57) **Abstract**

This invention is a method for making a semiconductor integrated circuit chip, adapted for mounting to a lead-over-chip lead frame, comprising the steps of (a) applying a uniform coating of an adhesive having a number average molecular weight in the range of 5,000 to 50,000 to a thickness of 0.1-5 mils to the surface of a silicon wafer that is detailed for microelectronics circuitry; (b) removing selected portions of the adhesive to expose bond pads on the surface of the wafer; (c) dicing the wafer to form individual semiconductor integrated circuit chips; (d) electrically and adhesively connecting the chips to a lead frame; (e) encapsulating the chip and the lead frame in a polymeric sealant.

## Description

This invention pertains to a method for manufacturing a semiconductor integrated circuit chip adapted for mounting to a lead-over-chip lead frame, to the semiconductor chip made by that method, and to an encapsulated semiconductor module containing that chip.

The manufacturing precursor to semiconductor integrated circuit chips for use in microelectronics applications is a thin silicon wafer with a diameter of approximately two to eight (2-8) inches. Integrated microcircuitry is detailed onto at least one surface of this wafer, defined as the active surface, and the wafer diced into a plurality of individual semiconductor chips. Semiconductor chips are sensitive to alpha particles and other environmental contaminants that can cause memory error or corrosion; consequently, the chips usually are encapsulated or packaged within a polymeric sealant and delivered as a composite semiconductor module.

In order to connect an encapsulated chip to external circuitry or a power supply, the chip is both adhesively and electrically attached to metal conductor leads that extend through the encapsulation. The metal conductor leads are produced from a lead frame of copper alloy or other suitable alloy cut to provide a plurality of the metal leads. Using a current technique known in the art as "lead-over-chip" or "lead-on-chip" (LOC), the lead frame is disposed over the active surface of the integrated circuit chip. It is bonded to the chip using a double-sided adhesive insulating tape, which typically consists of three layers, a first adhesive layer for contact with the chip, a center polymeric film that acts as an alpha barrier, and a second adhesive layer for contact with the conductor leads. In an alternate configuration, the adhesive may be a single layer of film.

To make electrical connection, the chips are also wire-bonded to the metal conductors with thin wires from bond pads detailed onto the active surface of the chip. This wire-bonding implicates the placement of the adhesive tape or film that mechanically attaches the chip to the lead frame. The tape cannot cover the bond pads, but at the same time it must be as close as possible to minimize the length of the wire bonds that lead from the bond pads to the conductors. Minimizing the length of the wires improves the electrical performance and reliability of the encapsulated chip. Encapsulation of the whole composite, typically in an epoxy or plastic sealant, takes place after the chip is wire-bonded to the lead frame; thus, minimizing the length of the wires also reduces the chances of breaking the wires during the encapsulation process. The use of the adhesive film or tape, which must be mechanically placed on the surface of the chip, therefore, can be a disadvantage in the manufacture of the semiconductor chip.

This invention improves on the prior art method of manufacturing semiconductor chips by depositing the adhesive for bonding the chips to the lead conductors directly onto the active surface of the silicon wafer, and etching away portions of the adhesive by photolithographic techniques to expose the bond pads, before the wafer is diced into chips. The adhesive is applied in a thickness sufficient to act as an alpha barrier and sufficient to bond the chip to the conductor leads. This method eliminates the requirement for using and applying an adhesive tape to the chip. The result is fewer interfaces, and better precision in placing conductor leads near the bond pads on the semiconductor chips because mechanical placement of the adhesive tape for bonding the leads to the chip is no longer a factor.

In another embodiment, this invention is a semiconductor integrated circuit chip having a layer of polyimide adhesive deposited on its active surface in an amount from 0.1 to 5 mils thick, characterized in that the polyimide acts as an alpha barrier and as an adhesive for bonding the chip to lead conductors. In a further embodiment, this invention is an encapsulated semiconductor chip.

The adhesive for bonding the chips to the lead frame is initially applied to the active surface of the wafer by any convenient technique for applying a uniform coating in thicknesses up to several mils. Suitable techniques include spin-on coating, roll coating, and spray coating, the preferred technique being spin-on coating, and the preferred thickness being in the range of one (1) mil.

Any adhesives that meet the thermal and adhesive requirements for attaching chips to lead frames, and that can be patterned either by selective deposition or selective removal, can be used in this manner. Examples of suitable adhesives are well known in the art and include epoxies, polyimides, acrylics and silicones; however, for reasons of performance, cost, and ionic purity, the preferred adhesive is a polyimide. The polyimide is applied in its precursor form as a polyamic acid, and upon curing becomes the polyimide. Suitable polyamic acids are formally the condensation products of aromatic dianhydrides and aromatic diamines. Compositions of polyamic acids for this use, and methods of preparation are well described in the literature, for example, in US patents 3,179,614 and 3,179,634, incorporated herein by reference.

The desired polyamic acid is dissolved in a suitable organic solvent to a solids content in the range of 20-50% and a workable viscosity in the range of 100-30,000 centipoises. The particular choice of polyamic acid and solvent for a particular microelectronics use is within the expertise of one skilled in the art. Whichever polyamic acid is chosen, it preferably will have a number average molecular weight in the range of 5,000 to 50,000, considerably lower than currently used in the art, which permits the use of a higher solids content while retaining a workable viscosity. The combination of low molecular weight and high solids content allows the deposit of a thick film of polyamic acid, from 0.1 to 5.0 mils, the preferred range for application and adhesion being 0.5-1.5 mils. This range of thickness will provide both sufficient adhesion of the chip to the lead frame and sufficient protection to the chip from contaminants.

For many applications, it may be preferable to apply an adhesion promoter to the wafer before applying the adhesive. If an adhesion promoter is used, it is chosen and used in an amount to promote adhesion for the adhesive used; these materials and amounts are known in the art. Suitable adhesion promoters for polyamic acids are aminosilanes.

The wafers with the deposited adhesive are then dried to remove solvent and provide a non-tacky surface. Drying times and temperatures will vary depending on the thickness of the adhesive layer and the solvent and composition of the formulation used. A typical drying scheme would entail an initial drying for a short time at low temperature, for example, for 10-15 minutes at approximately 50°C, and then further drying for 30 minutes or more at approximately 90°C. For thick films, greater than one (1) mil, it may be necessary to dry for 45-60 minutes at temperatures of 90° or greater. Oven drying is preferred over hot plate drying, although there may be some circumstances in which hot plate drying would be acceptable.

The application of the adhesive is made to the entire surface of the wafer; subsequently, therefore, portions of the adhesive must be removed to expose the bond pads for the wires that will lead to the metal conductors. Standard photolithography techniques are the preferred method of removal, although conventional wisdom in the art has been that photolithography is not preferred when the adhesive layer is thick. The supposed reason for avoiding this technique arises from the fact that the thicker the adhesive layer, the more difficult to obtain controlled removal. However, it can be recognized that although a thick film may not be patterned as fine as a thinner film, for this application fine patterning is not narrowly critical.

Photolithography techniques are known in the art and can briefly be described as follows. A conventional photoresist material is spun-on, or applied by other means, to the surface of the deposited adhesive. The surface is masked with a photographic template having either a positive or a negative pattern conforming to the placement of the bond pads on the active surface of the chip by spatially aligning the template with the bond pads. The wafer is then exposed to light at the appropriate wavelength for the photoresist selected, usually UV radiation, and the photoresist developed by treatment with a developer system for the particular photoresist. If a positive acting photoresist material is used, it will have been made more soluble by exposure to UV radiation in the developer than the unexposed photoresist. Positive acting photoresist is preferred because the developer can be chosen so that the underlying adhesive layer is also soluble in the developer, and thus, both the photoresist and the adhesive layer can be removed in the same step to expose the bond pads.

As is understood by those skilled in the art, if a negative acting photoresist is used, the exposed material becomes less soluble than the unexposed material. The template mask is designed as the positive or negative pattern of the chip circuitry to coincide with either a positive or negative acting photoresist.

The remaining unexposed photoresist is removed by any appropriate photoresist stripping techniques known in the art. After the patterning of the photoresist and the polyamic acid, and after the removal of the residual photoresist, the remaining polyamic acid is thermally cured to produce the desired polyimide. This curing step takes place under conditions sufficient to dehydrate and convert the polyamic acid linkages to the stable ring-closed imide form, usually 200°-400°C for 0.20-16 hours.

The wafers are diced into chips after the adhesive is deposited and patterned. The coated die is adhesively attached to the conductive lead frame with heat (200-350°C) and pressure (50-1000 psi) and electrically connected by wire-bonding. The assembly is then encapsulated in a molding compound, for example, by injection molding. Suitable molding compounds, such as, for example epoxy molding, are well known in the art, and the choice of molding compound and the conditions for the encapsulation are within the expertise of one skilled in the art.

### Examples

### Polyamic Acid Preparation

**BTDA/APB:** 3,3',4,4'-Benzophenone tetracarboxylic dianhydride (198.2g) was condensed with 178.4g 1,3-bis(3-aminophenoxy)benzene in 600 ml N-methyl pyrolodinone at 45°C for six hours. The product was filtered in a dust free environment through a standard 0.5 µ teflon filter membrane to give a 25,000 cps solution.

**SDA/APB:** Bis-[1,3-isobenzofurandione]-5,5'-thiobis(4,1-phenyleneoxy) (261.0g) was condensed with 148.8g 1,3-bis(3-aminophenoxy)benzene and 2.2g 4-hydroxy aniline in N-methyl pyrrolidinone at 45°C for six (6) hours. The product was isolated after 0.5 µ filtration as a 22,000 cps solution.

**Low viscosity BTDA/APB:** BTDA/APB polyamic acid solution (100 ml) was diluted with 18 ml prefiltered cyclopentanone to give a 13,000 cps solution.
**Example 1:** BTDA/APB polyamic acid solution was coated on the active surface of six (6) inch diameter, 11 mil thick silicon wafer containing active four (4) MegaBit DRAM (Dynamic Random Access Memory) circuitry. Standard spin-coating techniques were used to deposit approximately a 70 µ wet film. The wafer was dried in a forced-air oven at 90°C for 30 minutes to give a semi-dry 61 µ thick film. Hoechst-Celanese AZ-4620 positive acting photoresist was applied by spin-coating and dried on a hot plate at 90°C for 1-1/2 minutes. The resulting six (6) µ photoresist film was then exposed to a columated high pressure mercury light source through a standard glass photomask using the manufacturer's recommended conditions (25 milliwatt/cm², 45 second). The mask was designed and aligned to irradiate a variety of square and rectangular vias ranging in size from four (4) mil to 80 mil positioned over the bond pads of the active circuitry.

The exposed wafer was placed in a solution of Hoechst-Celanese AZ 327 MIF developer at 25°C and agitated gently for approximately 30 seconds. The wafer was removed and immediately rinsed with deionized water for 15 seconds. This develop/rinse cycle was repeated five times. The last water rinse was extended to 30 seconds. The wafer was dried in a stream of pressurized nitrogen at room temperature and then placed in a forced air oven at 120°C for two hours. After removal from the oven, the entire wafer was then exposed to the above mentioned UV radiation for 45 seconds. All of the remaining photoresist was removed by placing the wafer in Hoechst-Celanese AZ 400 K developer, diluted 1:1 with water. It was agitated gently for one minute, then removed and rinsed with deionized water for 30 seconds. Excess water was removed with a stream of pressurized nitrogen and the remaining patterned film was cured in a forced-air oven under the following conditions:
Room Temperature → 100°C at 5°C/ minute
Hold 30 minutes
100°C → 180°C at 5°C/minute
Hold 30 minutes
180°C → 300°C at 5°C/minute
Hold 120 minutes
300°C → 350°C at 5°C/minute
Hold 15 minutes
350°C → room temperature at -7°C/minute.

The coated wafer was diced to give 220 mil x 420 mil die with a patterned 40 µ thick adhesive coating.

The resulting die was attached to an alloy 42 "LOC type" lead frame by briefly heating the chip and the lead frame on a hot plate maintained at 290°C. The preheated chip was placed adhesive side down upon the heated lead frame and three (3) kg of pressure was applied for four (4) seconds. The entire assembly was removed from the hot plate and allowed to cool to room temperature.

At this point standard die shear adhesion testing (80 mil x 80 mil specimen) showed that shear force up to the point that the die shattered (10-15 kg) did not result in adhesive failure.

Standard plastic packages were then prepared from the assembly by first connecting the lead-frame fingers to the die bond pads using standard wire-bond technique followed by encapsulating the whole composite in epoxy base mold compound.
**Example 2:** The process of Example 1 was followed using the low viscosity BTDA/APB polyamic acid solution. Spin coating conditions were adjusted to yield 14 µ film thickness after initial drying. Only two develop/rinse cycles were used in this case. Final film thickness after cure was ten (10) µ. Die attach was done at 310°C and 0.5 kg pressure. Die shear testing (80 mil x 80 mil specimen) resulted in die breakage at 10 - 15 kg.
**Example 3:** The process of Example 1 was followed using the SDA/APB polyamic acid solution on six (6) inch, blank, uncircuitized wafers. The wire-bonding and encapsulation steps were not performed. Film thickness after initial drying was 47 µ and 35 µ after final cure. Die attach was performed at three (3) kg pressure and a range of temperatures from 220°C to 340°C. Table 1 shows the resulting die shear strength (80 mil x 80 mil specimen).

**TABLE 1**

| Attach Temperature (°C) | Die Shear Strength (kg) |
|---|---|
| 220 | 0.0 |
| 230 | 0.1 |
| 240 | 0.1 |
| 250 | 0.5 |
| 260 | 1.8 |
| 270 | 2.4 |
| 280 | 5.0 |
| 290 | 6.2 |
| 300 | 7.8 |
| 320 | 10 (die breakage) |
| 340 | 11 (die breakage) |

## Claims

1. A method for making a semiconductor integrated circuit chip, adapted for mounting to a lead-over-chip lead frame, comprising the steps of:
(a) applying a uniform coating of an adhesive having a number average molecular weight in the range of 5,000 to 50,000 to a thickness of 0.1-5 mils to the surface of a silicon wafer that is detailed for microelectronics circuitry;
(b) removing selected portions of the adhesive to expose bond pads on the surface of the wafer;
(c) dicing the wafer to form individual semiconductor integrated circuit chips;
(d) electrically and adhesively connecting the chips to a lead frame;
(e) encapsulating the chip and the lead frame in a polymeric sealant.

2. The method according to claim 1 in which the adhesive is spun onto the silicon wafer.

3. The method according to claim 1 in which the adhesive is applied as a polyamic acid and converted by curing to a polyimide.

4. The method according to claim 1 in which selected portions of the adhesive are removed by photolithography techniques.

5. A semiconductor integrated circuit chip made by the method comprising the sequential steps of:
(a) applying a uniform coating of an adhesive having a number average molecular weight in the range of 5,000 to 50,000 to a thickness of 0.1-5 mils to the surface of a silicon wafer that is detailed for microelectronics circuitry;
(b) removing selected portions of the adhesive to expose bond pads on the surface of the wafer;
(c) dicing the wafer to form individual semiconductor integrated circuit chips.

6. An encapsulated semiconductor module made by the method comprising the steps of:
(a) applying a uniform coating of an adhesive having a number average molecular weight in the range of 5,000 to 50,000 to a thickness of 0.1-5 mils to the surface of a silicon wafer that is detailed for microelectronics circuitry;
(b) removing selected portions of the adhesive to expose bond pads on the surface of the wafer;
(c) dicing the wafer to form individual semiconductor integrated circuit chips;
(d) electrically and adhesively connecting the chips to a lead frame;
(e) encapsulating the chip and the lead frame in a polymeric sealant.
